# EUROPEAN PATENT APPLICATION

(11) **EP 1 484 899 A2**
(43) Date of publication of application: **08.12.2004**
(21) Application number: 04252789.5
(22) Date of filing: 13.05.2004
(51) Int. Cl.: H04L 29/08

(54) **Distributed system**

(30) Priority: 04.06.2003 US 454291
(71) Applicant: Agilent Technologies, Inc., Palo Alto, CA 94306 (US)
(72) Inventor: Eidson, John C., Palo Alto, California 94303 (US)
(74) Representative: Jehan, Robert

(57) **Abstract**

A distributed system that may employ distributed devices having a relatively limited memory capacity and/or a relatively limited communication capability. A distributed system according to the present teachings uses approximate information preservation techniques to represent at set of data using selected subsets of the data. A distributed system according to the present techniques includes a first device (10) that selects a subset of a set of data using a model (16) and that transmits the subset via a communication channel and further includes a second device 920) that obtains the subset from the first device (10) and in response generates a representation of the data using the model (16).

## Description

The present invention relates to a distributed system and to a method of approximate information preservation.

A wide variety of distributed systems may include distributed devices that transfer data via communication paths. A distributed device may be a device that generates data or a device that performs computations or other operations on data. A distributed measurement system, for example, may include distributed measurement devices that generate measurement data and transmit the obtained measurement data to information logging devices and/or computational devices.

A distributed device usually includes an internal memory for buffering data. A distributed measurement device, for example, typically includes an internal memory that buffers obtained measurement data. Similarly, information logging devices and computational devices usually include internal memories that buffer data obtained from measurement devices and/or buffer data to be transmitted to other distributed devices.

A distributed device may have a relatively limited internal memory capacity and/or a relatively limited communication capability. Unfortunately, a distributed device having a limited internal memory capacity and/or a limited communication capability may hinder the performance of a distributed system. For example, a relatively low available bandwidth or intermittent communication between a measurement device and a data logging facility may cause an overrun of the low capacity internal memory in the measurement device. An overrun of the internal memory in a measurement device may cause the loss of valuable measurement data. In addition, a relatively low capacity internal memory in a computational device may limit the ability of a measurement device to transit data to the computational device.

The present invention seeks to provide an improved distributed system and method of preserving data in such a system.

According to an aspect of the present invention, there is provided a distributed system as specified in claim 1.

According to another aspect of the present invention, there is provided a method of approximate information preservation as specified in claim 6.

A distributed system is disclosed that may employ distributed devices having a relatively limited memory capacity and/or a relatively limited communication capability. A distributed system according to the present teachings uses approximate information preservation techniques to represent a set of data using selected subsets of the data.

A distributed system according to the preferred embodiment includes a first device that selects a subset of a set of data using a model and that transmits the subset via a communication channel and further includes a second device that obtains the subset from the first device and in response generates a representation of the data using the model. The model may include a set of representation functions and a tolerance and a fitting criteria such that the subset enables the second device to generate the representation of the data within the tolerance. A substitution of a full set of data with a selected subset enables a conservation of memory space in a distributed device and a reduction in bandwidth utilization on a communication channel to a distributed device.

Embodiments of the present invention are described below, by way of example only, with reference to the accompanying drawings in which:
**Figure 1** shows a distributed system according to the present teachings;
**Figure 2** is a graph that shows a collection of points representing samples or data of a variable Y that is a function of X;
**Figure 3** shows another distributed system according to the present teachings;
**Figure 4** shows a distributed device in one embodiment.

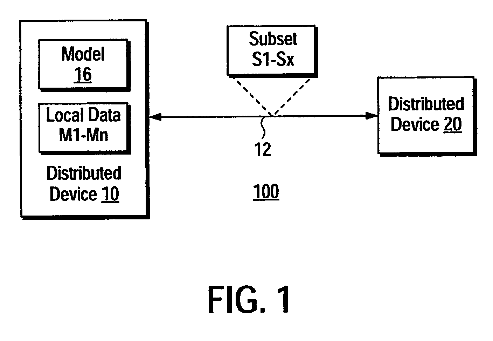

**Figure 1** shows a distributed system 100 according to the present teachings. The distributed system 100 includes a distributed device 10 and a distributed device 20. The distributed device 10 communicates with the distributed device 20 via a communication channel 12. The distributed device 10 yields a set of local data M1-Mn. The distributed device 10 selects a subset S1-Sx of the local data M1-Mn and then transmits the selected subset S1-Sx to the distributed device 20 via the communication channel 12. The distributed device 10 selects the subset S1-Sx such that the full set of local data M1-Mn may be viewed or represented using the subset S1-Sx and a model 16. The distributed device 20 receives the subset S1-Sx via the communication channel 12 and uses the subset S1-Sx together with the model 16 to generate a representation of the full set of local data M1-Mn.

The distributed device 20 may assume that the model 16 was used to select the subset S1-Sx. Alternatively, the distributed device 10 may transmit an identification to the distributed device 20 of which of a set of possible models was used to select the subset S1-Sx. The identification may be transmitted with the subset S1-Sx or separately.

The distributed device 10 may be a device having an internal memory with a relatively limited capacity. The distributed device 10 may be a device having a relatively limited communication capability. For example, the amount of available bandwidth on the communication channel 12 may be relatively limited. In another example, the communication channel 12 may be a wireless channel and the distributed device 10 may be a device having a limited power capability for sustaining wireless communication. The distributed device 10 may be a device characterized by any combination of limited memory, limited communication capability, and limited power capability. The distributed device 10 may be embodied in a portable/handheld device. Examples included portable telephones including cell phones, personal digital assistants (PDAs), or other more specialized devices.

Similarly, the distributed device 20 may be a device characterized by any combination of limited memory, limited communication capability, and limited power capability.

In one embodiment, the distributed device 10 is a measurement device and the local data M1-Mn is a set of obtained measurement data. In this embodiment, the distributed device 20 may be an information logging facility, e.g. a data base server, or a computational device that performs computations that pertain to the measurement local data M1-Mn.

The number of elements x in the subset S1-Sx may be selected according to the bandwidth capacity of the communication channel 12 and a data rate at which data is yielded by the distributed device 10. For example, a relatively high data rate and a relatively low bandwidth capacity may require a relatively low number x whereas a relatively low data rate or a relatively high bandwidth capacity may allow a higher number x.

The distributed device 10 may include an internal memory for holding the local data M1-Mn. The distributed device 10 may select the subset S1-Sx from among the local data M1-Mn stored in the internal memory and transmit the subset S1-Sx so as to free up space in the internal memory. The freeing of space in the internal memory may prevent an overrun of the internal memory as additional data are obtained by the distributed device 10. The number of data x in the subset S1-Sx may be selected according to the bandwidth capacity of the communication channel 12 and the data rate so as to prevent an internal memory overrun. For example, a relatively low capacity internal memory and/or a relatively low amount of available bandwidth on the communication channel 12 may require a relatively low number x. Conversely, a relatively high capacity internal memory and/or a relatively high available bandwidth on the communication channel 12 may allow a relatively high number x.

During periods when the communication channel 12 is not active, the distributed device 10 may select the subset S1-Sx and retain the subset S1-Sx in an internal memory while discarding the local data M1-Mn from the internal memory. This frees up space in the internal memory for new data while preventing overrun of the internal memory during a temporary communication loss or while the communication channel 12 is inactive or when communication is impractical.

The distributed device 10 may select and transmit the subset S1-Sx in place of the local data M1-Mn so as to lower the power consumption of the distributed device 10. For example, the distributed device 10 may run on a battery that discharges at a faster rate while the communication channel 12 is active. The distributed device 10 in such an embodiment may select and transmit the subset S1-Sx in order to reduce power consumption over the power consumption that would occur if all of the local data M1-Mn were transmitted to the distributed device 20.

The distributed device 10 may select and transmit the subset S1-Sx in place of the local data M1-Mn so as to lower the amount of memory space in the distributed device 20 needed to store the data from the distributed device 10.

The distributed device 10 may select and transmit and/or retain the subset S1-Sx in response to any combination of bandwidth constraints, power consumption constraints, and restrictions on communication.

The distributed device 20 receives the subset S1-Sx via the communication channel 12 and uses the subset S1-Sx and the model 16 used by the distributed device 10 to select the subset S1-Sx to determine the remainder of the local data M1-Mn. The representation of the local data M1-Mn generated by the distributed device 20 may provide an accuracy and confidence in accordance with the selection of the subset S1-Sx by the distributed device 10.

In one embodiment, the model 16 includes a class of models that may be referred to as Approximate Information Preservation using Subsets (AIPUS) models. The distributed device 10 uses the AIPUS models to select the subset S1-Sx from among its full set of local data M1-Mn. The AIPUS models view the local data M1-Mn as a set of multiple data or samples of an underlying variable that is distributed over space and/or time. The class of AIPUS models takes a data set with N members, a set of representation functions {R}, a tolerance ε, and a fitting criteria *f*, and produces a subset of members S such that the members of S in conjunction with the representation functions {R} and fitting criteria *f* provide an approximation to a model based on the entire data set N to a tolerance ε. For example, the set of functions {R} may be a set of polynomials of degree 4 or less, radial basis function or other functions deemed suitable. The fitting criteria *f* may be least squares or minimum maximum deviation. The tolerance ε may be an absolute number such as 0.01 in the units of the variable being modeled.

The number of members x of the set S will be the fewest number required to meet the criteria. Consider the following constraints on the distributed device 10. The constraints may include a constraint on an amount of free memory in the distributed device 10 to the extent that it is no longer possible to hold all N points of the local data M1-Mn. The constraints may include the need to send the local data M1-Mn to the distributed device 20 but the available communication bandwidth on the communication channel 12 is insufficient or the energy available, etc. does not permit transmission of the entire set of N members of the local data M1-Mn.

In both cases and for similar situations, the distributed device 10 selects subset S1-Sx using an AIPUS model such that the size x of the resulting subset S meets the constraints. There may be a trade-off between the number of members x in the subset S and the tolerance ε.

Now consider the information that may be obtained from the subset S1-Sx along with the knowledge of the functions {R} and the fitting criteria *f* and the tolerance ε. A complete set of the local data M1-Mn is not obtainable. However, the following information is obtainable. First, a subset S1-Sx of actual data points from the original set of local data M1-Mn. In addition, the knowledge is available that all the remaining points of the local data M1-Mn can be predicted within the tolerance ε of the function representations {R} using the fitting criteria *f* as the criteria for tolerance.

In contrast, the usual methods of curve fitting to the functions {R} and the fitting criteria *f* and the tolerance ε (for example a least square fit) produces the set of coefficients for the functions {R}. The number of coefficients is usually less than the number of elements x in S but does not provide any of the original set of the local data M1-Mn. This can be a substantial disadvantage for a variety of applications.

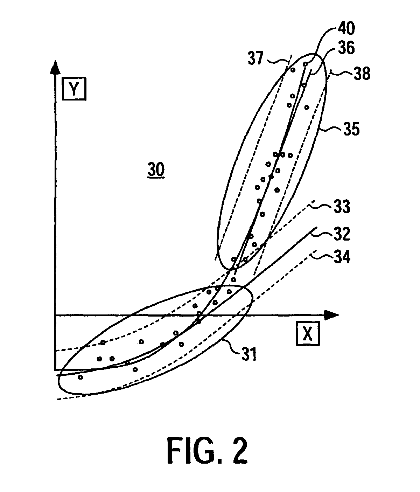

**Figure 2** is a graph 30 that shows a collection of points representing samples or data of a variable Y that is a function of X. A curve 40 shows the actual functional relationship which is not known. One motivation for obtaining data is to determine the nature of the relationship represented by the curve 40.

Consider an example in which the distributed device 10 obtains the 19 samples contained within a region 31 of the graph 30. The distributed device 10 is prevented from sending the samples from the region 31 to the distributed device 20 due to limitations on the communication channel 12 which will enable the transmission of a maximum of 8 samples. The distributed device 10 and the distributed device 20 have been configured to use AIPUS models for the model 16 where the functions {R} is the set of polynomials of degree 3 or less and the fitting criteria f is to minimize the maximum deviation. Under these conditions, the distributed device 10 selects a subset of the 19 samples contained within the region 31 such that the subset contains less than 9 members and the tolerance is minimal. In this example, the distributed device 10 selects a subset S1-Sx consisting of the 6 samples that fit a polynomial curve 32 shown on the graph 30 with a tolerance indicated by a pair of curves 33 and 34 shown on the graph 30.

It should be noted that this selection may not be a unique answer. For example, if the tolerance ε is increased or decreased then a different set of points may be selected. In the case of a large enough tolerance, any selection of points would suffice while for a zero tolerance there would be no solution for this example because the points in the region 31 cannot be represented exactly by cubic polynomials.

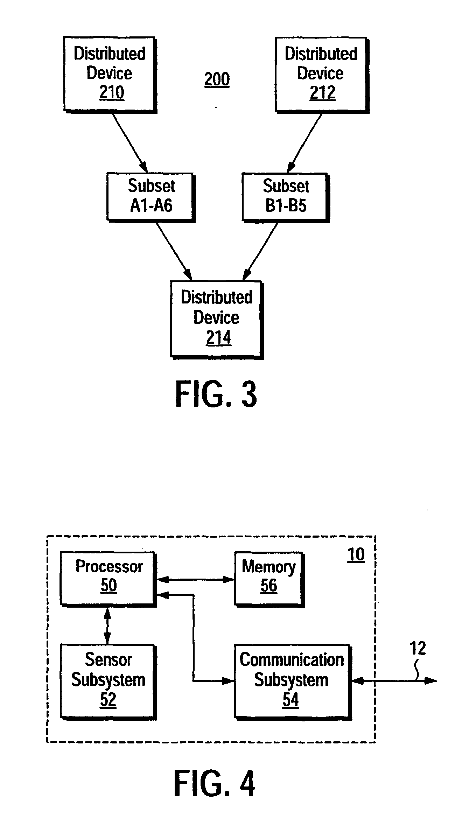

**Figure 3** shows a distributed system 200 according to the present teachings. The distributed system 200 includes a set of devices 210-214. Consider an extension of the above example in which the distributed device 210 obtains the 19 samples contained within the region 31 of the graph 30 and selects the 6 samples that fit the polynomial curve 32 shown on the graph 30, and transmits the 6 samples that fit the polynomial curve 32 to the distributed device 214 as a subset A1-A6 along with the tolerance ε_{A} indicated by the curves 33 and 34.

The distributed device 212 obtains the samples contained within a region 35 of the graph 30 and selects a subset B1-B5 consisting of the 5 samples that fit a polynomial curve 36 shown on the graph 30 with a tolerance indicated by a pair of curves 37 and 38 shown on the graph 30. In this case only 5 points are required to yield a tolerance ε_{B} that approximates the tolerance ε_{A}. The distributed device 212 transmits subset B1-B5 and the tolerance ε_{B} to the distributed device 214.

As a result, the distributed device 214 may model a larger range of the variable Y than either distributed device 210 or 212 may model alone. The distributed device 214 obtains the subset A1-A6 from the distributed device 210 and the subset B1-B5 from the distributed device 212 and fits the subsets A1-A6 and B1-B5 with a polynomial of degree 3. This may yield a curve near but not coincident with the curve 40 of the graph 30. The distributed device 214 may re-compute the polynomial and tolerance curves 32-34 computed by the distributed device 210. The distributed device 214 may then determine whether the tolerance values ε_{A} and ε_{B} when applied the polynomial fit determined by the distributed device 214 included the tolerance curves 33-34 and 37-38. In this way, an estimate of the overall correctness of the model employed by the distributed device 214 of the entire region may be obtained.

It should be noted that for a data point not included in the data of the devices 210-212 (the points not included within either region 31 or 35) the distributed device 214 may not render any absolute statement. However, if it appears to be within the tolerance established by the distributed device 214 and the projections of the tolerances of the devices 210-212 then it may be used with greater confidence. Thus, while the distributed device 214 has not received all of the data sampled by the devices 210-212 it has a useful representation of the relationship of Y to X even though it cannot regenerate all of the measured data.

As additional data is reported from other sources then the representation rendered by the distributed device 214 may be refined accordingly. The representation of the relationship rendered by the distributed device 214 may therefore be improved in spite of the communication limitation that prevents it from receiving all of the data. Given that an an AIPUS model is used to select the data transmitted to the distributed device 214, the representation rendered by the distributed device 214 is better than if, for example, pure decimation was used to reduce the amount of data transmitted by the devices 210-212. Moreover, the distributed device 214 has an actual estimate of the tolerance achieved.

The ALPUS models inherently are approximations involving tolerances and subsets of the available information. Note that there may be other configuration and operational possibilities. For example, all devices may use the same set of functions {R}, fitting criteria *f* and tolerance ε. In this case, there is no assurance that a subset of a given size may be found. Alternatively, all devices may select their own set of functions {R}, fitting criteria *f* and tolerance ε. The devices need only communicate the subsets and the information concerning the set of functions {R}, fitting criteria *f* and tolerance ε that are not part of the global configuration.

**Figure 4** shows the distributed device 10 in one embodiment. The distributed device 10 includes a processor 50, a sensor subsystem 52, a communication subsystem 54, and a memory 56.

The sensor subsystem 52 provides the physical capability for obtaining the local data M1-Mn. For example, the sensor subsystem 52 may include mechanisms for obtaining temperature data, pressure data, position data, image data (e.g. digital pictures), electrical signal data, chemical data, etc., just to name a few examples.

The communication subsystem 54 enables communication via the communication channel 12. In one embodiment, the communication subsystem 54 provides wireless radio communication via the communication channel 12. The wireless communication channel 12 may include a wireless telephone infrastructure. In other embodiments, wire-based communication may be used.

The processor 50 obtains the local data M1-Mn from the sensor subsystem 52 and writes the local data M1-Mn into the memory 56. One or more predetermined trigger conditions may cause the processor 50 to select the subset S1-Sx from among the local data M1-Mn using the probabilistic model 16.

One example of a trigger condition is the expiration of a predetermined time interval. A periodic triggering using a predetermined time interval causes the processor 50 to periodically replace a set of data held in the memory 56 with a selected subset. The processor 50 may provide each newly selected subset to the communication subsystem 54 for transmission via the communication channel 12.

Another example of a trigger condition is when an amount of available space in the memory 56 for holding data falls below a predetermined threshold. The processor 50 responds to this trigger condition and frees up space in the memory 56 by replacing a set of data held in the memory 56 with a selected subset of those data. The selected subset may be retained in the memory 56 or provided to the communication subsystem 54 for transmission via the communication channel 12.

Yet another example of a trigger condition is the loss of communication or a restriction of communication via the communication channel 12. If the communication channel 12 is wireless, for example, a communication loss may occur when the device moves out of range. A restriction may occur due to an increase in the volume of other communication traffic that lowers the available bandwidth on the communication channel 12. The processor 50 responds to a communication trigger condition by replacing a set of data held in the memory 56 with a selected subset of those data, thereby freeing up space in the memory 56 for new data until normal communication is restored.

Another example of a trigger condition is when an amount of available power from a battery in the distributed device 10 falls below a predetermined threshold. The reduction in data transmission via the communication channel 12 that results from transmitting a selected subset rather than a full set of obtained measurement reduces power consumption of the communication subsystem 54, thereby extending battery life.

The foregoing detailed description of the present invention is provided for the purposes of illustration and is not intended to be exhaustive or to limit the invention to the precise embodiment disclosed. Accordingly, the scope of the present invention is defined by the appended claims.

The disclosures in United States patent application no. 10/454,291, from which this application claims priority, and in the abstract accompanying this application are incorporated herein by reference.

## Claims

1. A distributed system, including:
a first device (10) operable to select a subset of a set of data using a model (16) and to transmit the subset via a communication channel;
a second device (20) operable to obtain the subset from the first device (10) and in response to use the model (16) and the subset to generate a representation of the data.

2. A distributed system as in claim 1, wherein the first device (10) is operable to transmit an identification of the model (16) from among a set of possible models to the second device (20) along with the subset.

3. A distributed system as in claim 1 or 2, wherein a number of elements in the subset is selected in response to a rate at which the data is obtained and an available bandwidth on the communication channel.

4. A distributed system as in claim 1, 2 or 3, wherein a number of elements in the subset is selected in response to an amount of available power in a battery for the first device (10).

5. A distributed system as in any preceding claim, wherein the data is held in an internal memory in the first device (10).

6. A method of Approximate Information Preservation in a distributed system, including the steps of:
selecting a subset of a set of data using a model (16);
transmitting the subset via a communication channel;
obtaining the subset via the communication channel and in response generating a representation of the data using the model (16).

7. A method as in claim 6, wherein the step of transmitting the subset includes the step of transmitting an identification of the model (16) from among a set of possible models.

8. A method as in claim 6 or 7, including the step of selecting a number of elements in the subset in response to a data rate associated with the data and an available bandwidth on the communication channel.

9. A method as in claim 6, 7 or 8, including the step of selecting a number of elements in the subset in response to an amount of available power for transmitting the subset.

10. A method as in claim 6, 7, 8 or 9, including the steps of storing the data in a memory and replacing the data in the memory with the subset.
